(19) Europäisches Patentamt / European Patent Office / Office européen des brevets

(11) **EP 4 535 070 A1**

(12) **EUROPEAN PATENT APPLICATION**

(43) Date of publication:
**09.04.2025 Bulletin 2025/15**

(21) Application number: **23306711.5**

(22) Date of filing: **05.10.2023**

(51) International Patent Classification (IPC):
**G02F 1/01** *(2006.01)*    **G02B 27/28** *(2006.01)*
**G03F 7/00** *(2006.01)*    **H01S 3/00** *(2006.01)*

(52) Cooperative Patent Classification (CPC):
**G02F 1/0136; G02B 27/286; G03F 7/70566; H01S 3/005**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(71) Applicant: **Pasqal**
**91300 Massy (FR)**

(72) Inventor: **BLOCH, Etienne**
**91300 MASSY (FR)**

(74) Representative: **Lavoix**
**2, place d'Estienne d'Orves**
**75441 Paris Cedex 09 (FR)**

(54) **A DEVICE FOR DYNAMICAL ADAPTATION OF THE PHASE OF AN INPUT LASER BEAM AND ASSOCIATED SYSTEM FOR GENERATING TRAPPING SITES FOR PARTICLES**

(57) The present invention relates to a device (14) for dynamical adaptation of the phase of an input laser beam ($B_i$), comprising:
- a first unit (20) suitable to spatially modify the polarization of the input laser beam ($B_i$) so as to obtain a non-uniformly polarized laser beam ($B_p$) with a center region having a first polarization and an outer region having a second polarization,

- a second unit (22) suitable to be switched between at least two configurations characterized by a specific phase difference to be applied between the center and the outer region of the non-uniformly polarized laser beam ($B_p$), so as to obtain an adapted laser beam ($B_a$), and
- a third unit (24) suitable to modify the polarization of the adapted laser ($B_a$).

FIG.1

EP 4 535 070 A1

**Description**

TECHNICAL FIELD OF THE INVENTION

The present invention concerns a device for dynamical adaptation of the phase of an input laser beam. The present invention also concerns a system for generating trapping sites for particles.

BACKGROUND OF THE INVENTION

Neutral atom-based quantum computing processors use optical tweezers to trap individual atoms. Such tweezers consist in an array of tightly focused laser beams, which are typically derived from a single laser source and split in several traps by a beam shaping device (e.g. spatial light modulator, acousto-optical deflectors, metasurfaces, ...). The atoms are trapped at the focus of the tweezers, where the light intensity is maximum.

To perform quantum calculations, several laser pulses are sent on the atoms which are initially in their fundamental state to make them go into an excited state.

However, in frequent cases such as for instance with 87Rb atoms excited to Rydberg states, a trap which is attractive for an atom in the fundamental state becomes repulsive when the atom is in an excited state. Hence, the traps need to be deactivated during quantum calculations. Nevertheless, due to thermal agitation, the atoms move from their initial positions and get lost, which limits the calculation time.

A solution would be to trap the excited atoms using another type of trap, such as a bottle beam trap. An example of a bottle beam trap is given in the article: J. Arlt and M. J. Padgett, "Generation of a beam with a dark focus surrounded by regions of higher intensity: the optical bottle beam," Opt. Lett. 25, 191-193 (2000).

Bottle beam traps can be created using destructive interferences between portions of a laser beam in which the phase at the center of the beam is different from the phase in the periphery (outer ring) of the beam.

Currently, to do that, two separate devices are used: a first laser source associated with a SLM for generating attractive traps for the fundamental state (Gaussian traps for example), and a second laser source associated with a SLM for generating the bottle beam traps. To switch between the Gaussian profile and the bottle beam profile, the first laser is turned off and the second laser is turned on and modulated by its SLM.

Nevertheless, this solution appears to be costly, cumbersome, and can cause misalignment problems between the two lasers due to drift over time.

SUMMARY OF THE INVENTION

Hence, there exists a need for a device suitable to be used in a system for generating trapping sites for particles so as to trap particles whatever the state of such particles, and in a time suitable for carrying out quantum calculations.

To this end, the invention relates to a device for dynamical adaptation of the phase of an input laser beam, the device comprising:

- a first unit suitable to spatially modify the polarization of the input laser beam so as to obtain a non-uniformly polarized laser beam with a center region having a first polarization and an outer region, surrounding the center region, having a second polarization, the first and the second polarizations being different,
- a second unit suitable to be switched between at least two configurations, each configuration being characterized by a specific phase difference to be applied, by the second unit, between the center and the outer region of the non-uniformly polarized laser beam resulting from the different polarization of each region, so as to obtain an adapted laser beam, and
- a third unit suitable to modify the polarization of the adapted laser beam so as to obtain an output laser beam with a spatially uniform polarization over the center region and the outer region of the output laser beam.

The device according to the invention may comprise one or more of the following features considered alone or in any combination that is technically possible:

- the first and the second polarizations are linear perpendicular polarization;
- the first unit is a holey half-wave plate, the center region of the non-uniformly polarized laser beam being the region of the input laser beam which has passed through the hole of the holey half-wave plate, the outer region of the non-uniformly polarized laser beam being the region of the input laser beam which has passed through the surface of the holey half-wave plate;
- the second unit comprises an electro-optics cell, such as a Pockels cell;
- the device also comprises a controller suitable for switching the second unit between the at least two configurations, preferably the switching being carried out over a predefined timing;
- the third unit is a holey half-wave plate so that the center region of the adapted laser beam passes through the hole of the holey half-wave plate and the outer region of the adapted laser beam passes through the surface of the holey half-wave plate; and
- the third unit is an optically polarizing element, preferably a polarizing cube.

The invention also relates to a system for generating trapping site(s) for particles, the system comprising:

- a laser source suitable to emit an input laser beam,
- a device suitable for dynamical adaptation of the phase of the input laser beam so as to obtain an output laser beam, the device being as previously described, and
- a beam shaper suitable to shape the output laser beam so as to generate one or several trapping sites for particles.

The system according to the invention may comprise one or more of the following features considered alone or in any combination that is technically possible:

- the system comprises a spatial light modulator or an acousto-optic deflector enabling the generation of several trapping sites;
- the particles have a fundamental state and an excited state, the second unit being configured to be switched between two configurations:

  - a first configuration for which the specific phase difference is such that the output laser beam shaped by the beam shaper generates trapping site(s) which are attractive for particles in the fundamental state and repulsive for particles in the excited state, and
  - a second configuration for which the specific phase difference is such that the output laser beam shaped by the beam shaper generates trapping site(s) which are repulsive for particles in the fundamental state and attractive for particles in the excited state;

- the input laser beam has a Gaussian shape, the specific phase difference of the second configuration being equal to $\pi$ modulo $2\pi$ so that the trapping sites generated by the beam shaper have a bottle beam shape;
- the input laser beam has a Gaussian shape, the specific phase difference of the first configuration being equal to zero modulo $2\pi$ so that the trapping sites generated by the beam shaper have a Gaussian shape;
- the input laser beam has a Gaussian shape, the specific phase difference of the first configuration being comprised between $\dfrac{\pi}{4}$ and $\dfrac{3\pi}{4}$ modulo $\pi$ so that the trapping sites generated by the beam shaper have a flat-top beam shape; and
- the controller is configured to switch the second unit in the first configuration when the particles are in the fundamental state and in the second configuration when the particles are in the excited state.

The invention also relates to a method for trapping particles in trapping sites, the method being carried out by a system as previously described, and comprising the following steps:

- the generation of an input laser beam by the laser source,
- the dynamical adaptation, by the device), of the phase of the input laser beam so as to obtain an output laser beam, and
- the shaping, by the beam shaper, of the output laser beam so as to generate one or several trapping sites for particles.

BRIEF DESCRIPTION OF THE DRAWINGS

The invention will be easier to understand in view of the following description, provided solely as an example and with reference to the appended drawings in which:

- Figure 1 is a schematic view of an example of a system for generating trapping site(s) for particles, the system comprising a device for dynamical adaptation of the phase of an input laser beam,
- Figure 2 is schematic view of an example of embodiment of the device of figure 1,
- Figure 3 is schematic view of an example of another embodiment of the device of figure 1, and
- Figure 4 is an example of the energy potential of trapping sites having different shapes: Gaussian, bottle beam and flat top beam.

DETAILED DESCRIPTION OF SOME EMBODIMENTS

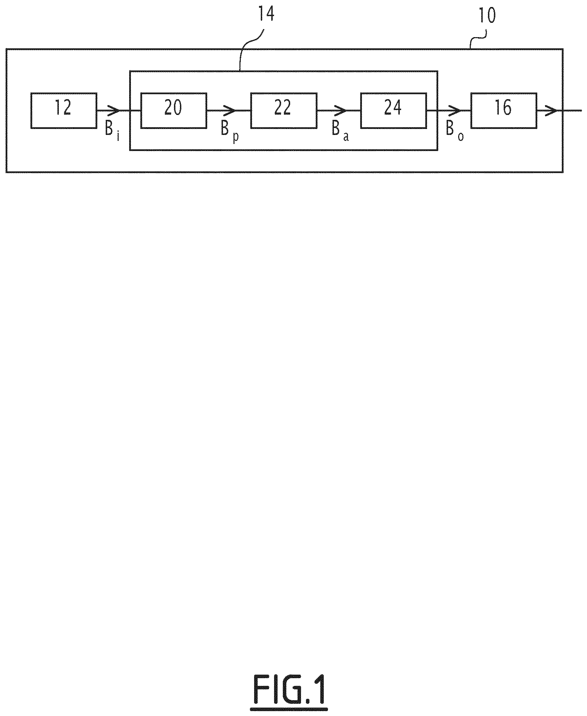

In the description, the terms "suitable for" and "configured for" are considered equivalent. The terms "trapping sites" and "traps" are also equivalent.
A system 10 for generating trapping site(s) for particle(s) is illustrated on figure 1.
The particles trapped in the trapping sites enable to generate an array of qubits, also called quantum register.
The system 10 may be part of an equipment, preferably a quantum equipment, such as a quantum computing processor (e.g., a quantum processing unit, or QPU).
In this case, the quantum computing processor generally comprises, in addition to the system 10, a source of particles, a detecting device and hardware elements.
In the case of neutral atoms, the source of particles comprises a vacuum chamber in which the particles (for example atoms) are located. In particular, during use, a vacuum is created in the vacuum chamber and a dilute atomic vapor is formed in the vacuum chamber. Other embodiments are nonetheless possible.
The detecting device is configured to detect the presence of a particle in each trapping site. The detecting device is, for example, a camera such as a charge-coupled device (CCD) camera, or any suitable imaging technology. For example, in the case of atoms, the camera is suitable to detect the fluorescence emitted from the atoms trapped in the trapping sites.

The hardware elements enable to manipulate the qubits generated by trapping particles with the system 10 so as to perform quantum operations on the qubits. Typically, the quantum equipment uses the quantum properties of matter, such as superposition and entanglement, to perform operations on the qubits. In particular, a qubit refers to a two-level quantum system.

In a non-limiting example, a qubit may comprise two basic quantum states |0> and |1> representing the possible quantum states of the qubit. According to the superposition principle of quantum mechanics, any superposition of the form a|0> + b|1> (a and b being complex numbers and aa*+bb*=1) is a possible quantum state of the qubit.

The particles meant to be trapped in the trapping sites are polarizable particles sensitive to alternative current (AC) Stark shift from lasers.

Preferably, the particles are atoms, and in particular electrically neutral atoms. Neutral atoms are, for example, Rubidium atoms, or Strontium atoms. In a variant, the particles are photons or molecules.

The particles have a fundamental state (no excitation) and at least one excited state. The excited state is, for example, a Rydberg state.

As illustrated on figure 1, the system 10 comprises a laser source 12, a device 14 and a beam shaper 16.

The laser source 12 is suitable to emit an input laser beam $B_i$.

In an example, the input laser beam $B_i$ has a spatially uniform phase and a spatially uniform polarization. In a variant, the input laser beam $B_i$ has a non-spatially uniform phase and/or a non-spatially uniform polarization.

Preferably, the input laser beam $B_i$ has a Gaussian intensity profile (shape).

Preferably, the polarization of the input laser beam $B_i$ is linear.

In an example, the input laser beam $B_i$ has a wavelength which is strictly above one wavelength of excitation of the considered particles. For example, the wavelength can be above 800 nm for Rubidium atoms.

The device 14 is configured for dynamical adaptation of the phase of the input laser beam $B_i$.

As illustrated on figure 1, the device 14 comprises a first unit 20, a second unit 22 and a third unit 24.

The first unit 20 is suitable to spatially modify the polarization of the input laser beam $B_i$ so as to obtain a non-uniformly polarized laser beam $B_p$ (also called polarization structured laser beam). The non-uniformly polarized laser beam $B_p$ has a center region and an outer region, surrounding the center region. The center region has a first polarization. The outer region has a second polarization. The first and the second polarizations are different.

Preferably, the first polarization is the same polarization as the input laser beam $B_i$ and only the second polarization is different.

Preferably, the first and the second polarizations are linear perpendicular polarizations.

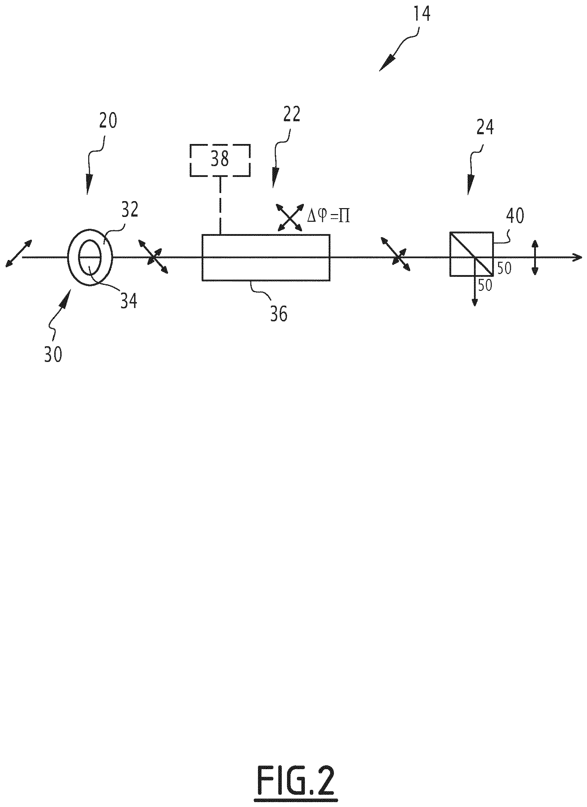

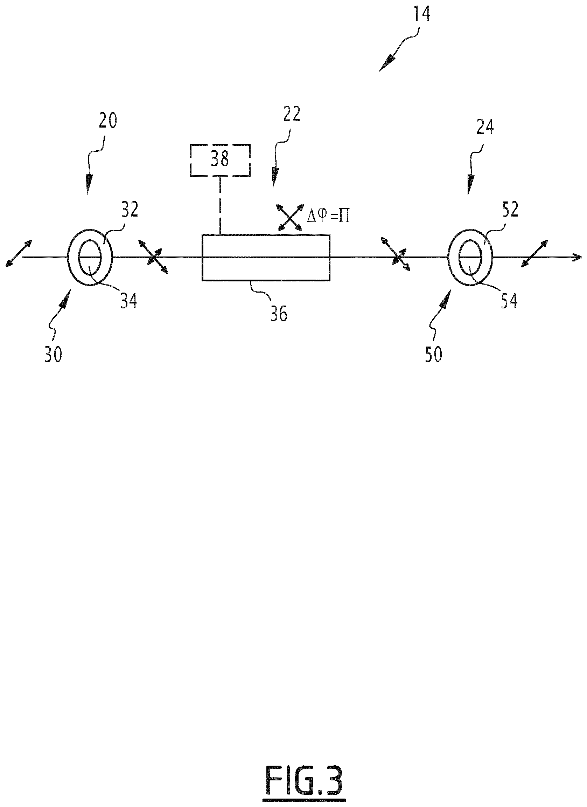

In an example of implementation, as illustrated on figures 2 and 3, the first unit 20 is a holey half-wave plate 30. The holey half-wave plate 30 has a surface 32 (preferably circular) with a hole 34 inside the surface 32 (preferably a circular hole centered at the middle of the surface 32).

A half-wave plate is a type of retarder plate, which is used to modify the polarization state of light. Half-wave plates are plates with parallel faces made from a birefringent material that allow a phase delay of $\lambda/2$ to be introduced in the light between the two axes of birefringence known as the slow axis and the fast axis.

The center region of the non-uniformly polarized laser beam $B_p$ is the region of the input laser beam $B_i$ which has passed through the hole 34 of the holey half-wave plate 30. The outer region of the non-uniformly polarized laser beam $B_p$ is the region of the input laser beam $B_i$ which has passed through the surface 32 of the holey half-wave plate 30.

Typically, the size of the input laser beam $B_i$ is adapted to the dimensions of the holey half-wave plate 30 so that the whole laser beam $B_i$ covers a significant fraction of the surface 32 of the holey half-wave plate 30. In a variant, the dimensions of the holey half-wave plate 30 are adapted for a given size of input laser beam $B_i$.

For example, in the case of the particle trapping application, the ratio between the radius of the hole 34 and the waist of the input Gaussian laser beam is chosen so that the generated trapping sites have a specific shape. For example, the ratio is inferior or equal to 0,8. The waist is a parameter defining the radial extension of the beam. The surface 32 of the half-wave plate 30 just has to be large enough to let the beam go through.

Alternatively, the first unit 20 is a half-wave plate with a central region that is not hollow, but which does not affect the polarization. The features listed above relative to the hole 34 applies to such a center region.

In a variant, the first unit 20 is a holey mirror that splits the central and the outer parts of the beam into two separate arms, one of which having its polarization rotated by using a conventional half waveplate, and then recombined together using a second holey mirror.

In another variant, the first unit 20 can be a device that could employ holey mirror, annular beams, deformable mirror, optical vortex beam, spiral phase plate, or Q-plate.

The second unit 22 is suitable to be switched between at least two configurations. Each configuration is characterized by a specific phase difference $\Delta\varphi$ to be applied, by the second unit 22, between the center and the outer region of the non-uniformly polarized laser

beam $B_p$ resulting from the different polarization of each region, so as to obtain an adapted laser beam $B_a$.

In an example of implementation, as illustrated on figures 2 and 3, the second unit 22 comprises an electro-optics cell 36, such as a Pockels cell. A Pockels cell is a device consisting of an electro-optic crystal (with some electrodes attached to it) through which a light beam can propagate. The phase delay in the crystal can be modulated by applying a variable electric voltage (Pockels effect). The Pockels cell is thus specifically used as a voltage-controlled birefringent material.

In a variant, the second unit 22 is an acousto-optic modulator (AOM), or any dynamical birefringence-controlled device.

Preferably, the device 14 also comprises a controller 38 suitable for switching the second unit 22 between the at least two configurations. Advantageously, the switching is carried out over a predefined timing (depending on the time needed for quantum calculations) or following the reception of an exterior command.

In an example of implementation, which is applicable when the device 14 is part of a system 10 for trapping particles, the second unit 22 is configured to be switched between two configurations:

- a first configuration for which the specific phase difference $\Delta\varphi$ is such that the output laser beam $B_o$ shaped by the beam shaper 16 generates trapping site(s) which are attractive for particles in the fundamental state and repulsive for particles in the excited state, and
- a second configuration for which the specific phase difference $\Delta\varphi$ is such that the output laser beam $B_o$ shaped by the beam shaper 16 generates trapping site(s) which are repulsive for particles in the fundamental state and attractive for particles in the excited state.

In this example, the controller 38 is advantageously configured to switch the second unit 22 in the first configuration when the particles are in the fundamental state and in the second configuration when the particles are in the excited state. For example, when the input laser beam $B_i$ has a Gaussian shape, the specific phase difference $\Delta\varphi$ of the second configuration is equal to $\pi$ (modulo $2\pi$) so that the trapping sites generated by the beam shaper 16 have a bottle beam shape.

In an example, the second unit 22 in the second configuration is configured to apply a phase equal to $\pi$ to a light having the first polarization and a phase equal to 0 to a light having the second polarization. Hence, in this example, the center region of the adapted laser beam $B_a$ has a phase equal to $\pi$ and its outer region a phase equal to 0. Such a phase difference $\Delta\varphi$ enables creating bottle beam traps with destructive interferences between the center region and the outer region of the output laser beam $B_o$ when the output laser beam $B_o$ is focused.

In a variant, the same result would have been obtained with reverse phase configuration (center region having a phase equal to zero and outer region having a phase equal to $\pi$). More broadly, this would work for any relative phase of $\pi$ modulo $2\pi$ or any relative phase approximately equal to $\pi$ modulo $2\pi$.

For example, when the input laser beam $B_i$ has a Gaussian shape, the specific phase difference $\Delta\varphi$ of the first configuration is equal to zero (modulo $2\pi$) so that the trapping sites generated by the beam shaper 16 have a Gaussian shape.

In an example, the second unit 22 in the first configuration does not apply any phase to the non-uniformly polarized laser beam $B_p$. Hence, the phase of the non-uniformly polarized laser beam $B_p$ is those of the input laser beam $B_i$ (spatially uniform over the center and the outer regions if this is the case for the input laser beam $B_i$). The second unit 22 is, for example, turned off. More broadly, this would work for any relative phase difference of 0 modulo $2\pi$.

For example, when the input laser beam $B_i$ has a Gaussian shape, the specific phase difference $\Delta\varphi$ of the first configuration is comprised between $\dfrac{\pi}{4}$ and $\dfrac{3\pi}{4}$ (modulo $\pi$) so that the trapping sites generated by the beam shaper 16 have a flat-top beam shape.

In an example, the second unit 22 in the first configuration is configured to apply a phase comprised between $\dfrac{\pi}{4}$ and $\dfrac{3\pi}{4}$ to a light having the first polarization and a phase equal to 0 to a light having the second polarization. Hence, the center region of the adapted laser beam $B_a$ has a phase comprised between $\dfrac{\pi}{4}$ and $\dfrac{3\pi}{4}$ and its outer region a phase equal to 0. Such a phase difference $\Delta\varphi$ enables creating flat top beam traps or nearly flat top beam traps (having flat top beam profile) with interferences between the center region and the outer region of the output laser beam $B_o$ when the output laser beam $B_o$ is focused. More broadly, this would work for any relative phase difference between $\dfrac{\pi}{4}$ and $\dfrac{3\pi}{4}$ modulo $\pi$.

Hence, by combining the above examples, the second unit 22 is for example switched so that the attractive traps for particles in the fundamental state have a Gaussian shape (specific phase difference $\Delta\varphi$ equal to 0), and that the attractive traps for particles in an excited state have a flat top beam shape (specific phase difference $\Delta\varphi$ equal to $\pi$) or a flat-top beam shape (specific phase difference $\Delta\varphi$ comprised between $\dfrac{\pi}{4}$ and $\dfrac{3\pi}{4}$).

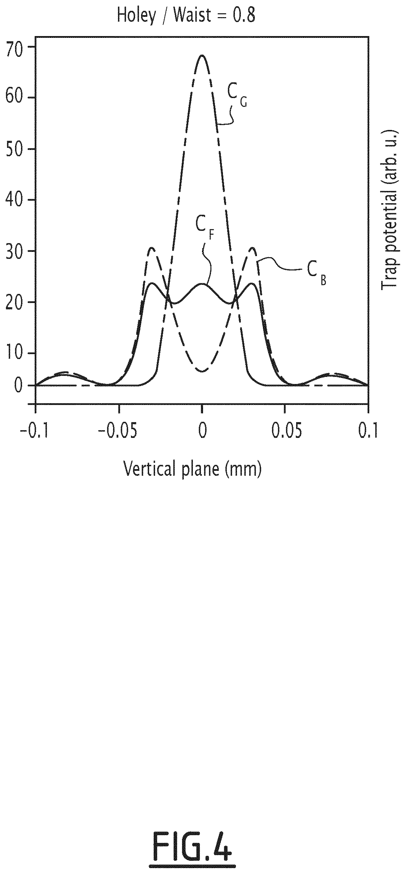

Figure 4 is an example of different intensity profiles obtained for different configurations of the second unit 22. In this example, the ratio between the radius of the hole 34 and the waist of the input laser beam $B_i$ is equal to 0,8. The Gaussian profile $C_G$ is obtained for a first configuration with a specific phase difference $\Delta\varphi$ equal to 0. The flat top beam profile $C_F$ is obtained for a first configuration with a specific phase difference $\Delta\varphi$ equal for instance to $0,65\pi$. The bottle beam profile $C_B$ is obtained for a second configuration with a specific phase difference $\Delta\varphi$ equal to $\pi$.

In a variant, the input laser beam $B_i$ has a bottlebeam shape and the device 14 is used either to leave it bottlebeam, or activated to switch it back to Gaussian.

The third unit 24 is suitable to modify the polarization of the adapted laser beam $B_a$ so as to obtain an output laser beam $B_o$. The output laser beam $B_o$ has a spatially uniform polarization over the center region and the outer region of the output laser beam $B_o$.

The uniform polarization is preferably a linear polarization. The uniform polarization can be the same polarization than the input laser beam $B_i$, but can also be different.

In a first example of implementation, as illustrated on figure 2, the third unit 24 is an optically polarizing element, preferably a polarizing cube 40. A polarizing cube enables to output, on one side of the cube, the light corresponding to a linear polarization (for example vertical) and, on another side of the cube, the light corresponding to an orthogonal linear polarization (for example horizontal). Using a polarizing cube 40 for the third unit 24 enables an easier alignment than a holey half-wave plate. However, 50% of the power is lost.

In a second example of implementation, as illustrated on figure 3, the third unit 24 is a holey half-wave plate 50 with a surface 52 and a hole 54 so that the center region of the adapted laser beam $B_a$ passes through the hole 54 of the holey half-wave plate 50 and the outer region of the adapted laser beam $B_a$ passes through the surface 52 of the holey half-wave plate 50. The use of a holey half-wave plate 50 for the third unit 24 enables to keep sensibly all the power. However, the alignment is more complex than for a holey half-wave plate.

Preferably, when the first unit 20 is also a holey half-wave plate 30, the holey half-wave plate 50 of the first unit 20 and of the third unit 24 are identical.

The beam shaper 16 is suitable to shape the output laser beam $B_o$ (e.g., to impart a specific intensity and/or phase pattern) so as to generate one or several trapping sites for particles.

In an example, the beam shaper 16 comprises a spatial light modulator (SLM) or an acousto-optic deflector enabling the generation of several trapping sites.

In another example, the beam shaper 16 only comprises a focusing unit (e.g. a convergent lens) for the generation of a single trapping site at the focus point of the focusing unit.

An example of a method for trapping particles in trapping sites using the system 10 will now be described.

The laser source 12 generates an input laser beam $B_i$. In an example, when the input laser beam $B_i$ is a Gaussian beam, the input laser beam $B_i$ has a spatially uniform phase and a spatially uniform polarization. In a variant, the input laser beam $B_i$ has a non-spatially uniform phase and/or a non-spatially uniform polarization.

The first unit 20 modifies the polarization of the input laser beam $B_i$ so as to obtain a non-uniformly polarized laser beam $B_p$ having the first polarization for the center region and the second polarization for the outer region. For example, the first polarization is the polarization of the input laser beam $B_i$ and the second polarization is modified, for instance rotated by 90°.

The particles being initially in their fundamental state, the second unit 22 is switched in the first configuration so as to generate attractive trapping sites for particles in the fundamental state. The second unit 22 sets the phase of the center region and of the outer region of the non-uniformly polarized laser beam $B_p$ so as to obtain an adapted laser beam $B_a$. For example, the specific phase difference $\Delta\varphi$ is equal to 0. In a variant, the specific phase difference $\Delta\varphi$ is comprised between $\dfrac{\pi}{4}$ and $\dfrac{3\pi}{4}$.

The third unit 24 modifies the polarization of the adapted laser beam $B_a$ so as to obtain the output laser beam $B_o$. The polarizations of the center region and of the outer region of the output laser beam $B_o$ are the same.

The beam shaper 16 then shapes the output laser beam $B_o$ so as to generate one or several trapping sites for particles. When the input laser beam $B_i$ is a Gaussian beam and the specific phase difference $\Delta\varphi$ is equal to 0, the trapping sites have a Gaussian shape. When the input laser beam $B_i$ is a Gaussian beam and the specific phase difference $\Delta\varphi$ is comprised between $\dfrac{\pi}{4}$ and $\dfrac{3\pi}{4}$, the trapping sites have a flat-top beam shape.

When the particles are being excited (for example passage in a Rydberg state), the second unit 22 is switched in the second configuration, and the preceding steps are repeated. In this case, the generated traps are attractive for particles in the excited state (and repulsive for the fundamental state). For example, when the input laser beam $B_i$ is a Gaussian beam and the specific phase difference $\Delta\varphi$ is equal to $\pi$, the trapping sites have a bottle beam shape.

Hence, the above device 14 enables to easily change the phase between the center region and the outer region of a laser beam. This enables generating different types of trapping sites (Gaussian, bottle beam, flat top beam) for particles so as to trap particles whatever the state of such particles and in a time suitable for carrying out quantum calculations.

In particular, because there is only one input laser beam $B_i$ (one laser source 12), the issue of misalignment no longer exists.

When using Pockels cells for the second unit 22, such Pockel cells can be switched on and off very rapidly. Thanks to this, switching between the two configurations (Gaussian or flat-top beam, and bottle beam) is fast enough compared to the Rydberg state lifetime or the time for which an untrapped particle stays in the vicinity of the trap before escaping (typ. <10ps).

The person skilled in the art will understand than the description gave example of specific trapping sites profile (Gaussian, bottle beam, flat top beam), however other types of profile can be used.

The person skilled in the art will understand that the embodiments and variants described above in the description can all be combined provided that they are technically compatible. Many other embodiments are possible without departing from the scope of the invention defined in the appended claims.

**Claims**

1. A device (14) for dynamical adaptation of the phase of an input laser beam ($B_i$), the device (14) comprising:

   - a first unit (20) suitable to spatially modify the polarization of the input laser beam ($B_i$) so as to obtain a non-uniformly polarized laser beam ($B_p$) with a center region having a first polarization and an outer region, surrounding the center region, having a second polarization, the first and the second polarizations being different,
   - a second unit (22) suitable to be switched between at least two configurations, each configuration being **characterized by** a specific phase difference ($\Delta\varphi$) to be applied, by the second unit (22), between the center and the outer region of the non-uniformly polarized laser beam ($B_p$) resulting from the different polarization of each region, so as to obtain an adapted laser beam ($B_a$), and
   - a third unit (24) suitable to modify the polarization of the adapted laser ($B_a$) beam so as to obtain an output laser beam ($B_o$) with a spatially uniform polarization over the center region and the outer region of the output laser beam ($B_o$).

2. A device (14) according to claim 1, wherein the first and the second polarizations are linear perpendicular polarizations.

3. A device (14) according to claim 1 or 2, wherein the first unit (20) is a holey half-wave plate (30), the center region of the non-uniformly polarized laser beam ($B_p$) being the region of the input laser beam ($B_i$) which has passed through the hole (34) of the holey half-wave plate (30), the outer region of the non-uniformly polarized laser beam ($B_p$) being the region of the input laser beam ($B_i$) which has passed through the surface (32) of the holey half-wave plate (30).

4. A device (14) according to any one of claims 1 to 3, wherein the second unit (22) comprises an electro-optics cell (36), such as a Pockels cell.

5. A device (14) according to any one of claims 1 to 4, wherein the device (14) also comprises a controller (38) suitable for switching the second unit (22) between the at least two configurations, preferably the switching being carried out over a predefined timing.

6. A device (14) according to any one of claims 1 to 5, wherein the third unit (24) is a holey half-wave plate (50) so that the center region of the adapted laser beam ($B_a$) passes through the hole (54) of the holey half-wave plate (50) and the outer region of the adapted laser beam ($B_a$) passes through the surface (52) of the holey half-wave plate (50).

7. A device (14) according to any one of claims 1 to 5, wherein the third unit (24) is an optically polarizing element, preferably a polarizing cube (40).

8. A system (10) for generating trapping site(s) for particles, the system (10) comprising:

   - a laser source (12) suitable to emit an input laser beam ($B_i$),
   - a device (14) suitable for dynamical adaptation of the phase of the input laser beam ($B_i$) so as to obtain an output laser beam ($B_o$), the device (14) being according to any one of claims 1 to 7, and
   - a beam shaper (16) suitable to shape the output laser beam ($B_o$) so as to generate one or several trapping sites for particles.

9. A system (10) according to claim 8, wherein the beam shaper (16) comprises a spatial light modulator or an acousto-optic deflector enabling the generation of several trapping sites.

10. A system (10) according to claim 8 or 9, wherein the particles have a fundamental state and an excited state, the second unit (22) being configured to be switched between two configurations:

    - a first configuration for which the specific phase difference ($\Delta\varphi$) is such that the output laser beam ($B_o$) shaped by the beam shaper (16) generates trapping site(s) which are attractive for particles in the fundamental state and repulsive for particles in the excited state, and
    - a second configuration for which the specific phase difference ($\Delta\varphi$) is such that the output

laser beam ($B_o$) shaped by the beam shaper (16) generates trapping site(s) which are repulsive for particles in the fundamental state and attractive for particles in the excited state.

11. A system (10) according to claim 10, wherein the input laser beam ($B_i$) has a Gaussian shape, the specific phase difference ($\Delta\varphi$) of the second configuration being equal to $\pi$ modulo $2\pi$ so that the trapping sites generated by the beam shaper (16) have a bottle beam shape.

12. A system (10) according to claim 10 or 11, wherein the input laser beam ($B_i$) has a Gaussian shape, the specific phase difference ($\Delta\varphi$) of the first configuration being equal to zero modulo $2\pi$ so that the trapping sites generated by the beam shaper (16) have a Gaussian shape.

13. A system (10) according to claim 10 or 11, wherein the input laser beam ($B_i$) has a Gaussian shape, the specific phase difference ($\Delta\varphi$) of the first configuration being comprised between $\dfrac{\pi}{4}$ and $\dfrac{3\pi}{4}$ modulo $\pi$ so that the trapping sites generated by the beam shaper (16) have a flat-top beam shape.

14. A system (10) according to any one of claims 10 to 13, in their dependency of claim 5, wherein the controller (38) is configured to switch the second unit (22) in the first configuration when the particles are in the fundamental state and in the second configuration when the particles are in the excited state.

15. A method for trapping particles in trapping sites, the method being carried out by a system (10) according to any one of claims 8 to 14, and comprising the following steps:

    - the generation of an input laser beam ($B_i$) by the laser source (12),
    - the dynamical adaptation, by the device (14), of the phase of the input laser beam ($B_i$) so as to obtain an output laser beam ($B_o$), and
    - the shaping, by the beam shaper (16), of the output laser beam ($B_o$) so as to generate one or several trapping sites for particles.

FIG.1

14

20

22

24

38

32

Δφ =Π

40

30

34

36

50

50

# FIG.2

Δφ = Π

FIG.3

Holey / Waist = 0.8

FIG.4

Europäisches
Patentamt

European
Patent Office

Office européen
des brevets

# EUROPEAN SEARCH REPORT

Application Number

EP 23 30 6711

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | QIWEN ZHAN: "Cylindrical vector beams: from mathematical concepts to applications", ADVANCES IN OPTICS AND PHOTONICS, vol. 1, no. 1, 1 January 2009 (2009-01-01), page 1, XP055324630, DOI: 10.1364/AOP.1.000001 * the whole document * | 1,8,15 | INV. G02F1/01 G02B27/28 G03F7/00 H01S3/00 |
| X | SROOR HEND ET AL: "Vector quality measure for vector beams", PROCEEDINGS OF SPIE; [PROCEEDINGS OF SPIE ISSN 0277-786X VOLUME 10524], SPIE, US, vol. 9950, 27 September 2016 (2016-09-27), pages 99500F-99500F, XP060079714, DOI: 10.1117/12.2237695 ISBN: 978-1-5106-1533-5 * the whole document * | 1 | |
| X | MCLAREN MELANIE ET AL: "Classical entanglement of vector vortex beams", PROCEEDINGS OF SPIE, IEEE, US, vol. 9581, 25 August 2015 (2015-08-25), pages 958106-958106, XP060060180, DOI: 10.1117/12.2187915 ISBN: 978-1-62841-730-2 * the whole document * | 1 | **TECHNICAL FIELDS SEARCHED (IPC)** G02F G03F H01S G02B |
| A | EP 2 965 852 A1 (UAB ALTECHNA R&D [LT]; UAB EKSPLA [LT]) 13 January 2016 (2016-01-13) * abstract; claim 1; figures 1,3,9,12-15 * * paragraphs [0044] - [0057], [0074] - [0082] * | 1-15 | |

-/--

The present search report has been drawn up for all claims

| Place of search | Date of completion of the search | Examiner |
|---|---|---|
| The Hague | 16 February 2024 | Beugin, Anne |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P04C01)

page 1 of 2

Europäisches
Patentamt

European
Patent Office

Office européen
des brevets

# EUROPEAN SEARCH REPORT

**Application Number**

**EP 23 30 6711**

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | EILEEN OTTE ET AL: "Customization and analysis of structured singular light fields", JOURNAL OF OPTICS, INSTITUTE OF PHYSICS PUBLISHING, BRISTOL GB, vol. 23, no. 7, 28 May 2021 (2021-05-28), page 73501, XP020367175, ISSN: 2040-8986, DOI: 10.1088/2040-8986/ABFF95 [retrieved on 2021-05-28] * the whole document * | 1-15 | |
| A | BHEBHE N A ET AL: "Generation of propagation invariant vector flat-top beams", PROCEEDINGS OF SPIE; [PROCEEDINGS OF SPIE; ISSN 0277-786X; VOL. 8615], SPIE, 1000 20TH ST. BELLINGHAM WA 98225-6705 USA, vol. 10744, 14 September 2018 (2018-09-14) , pages 1074411-1074411, XP060112075, DOI: 10.1117/12.2320887 ISBN: 978-1-5106-2099-5 * the whole document * | 1-15 | |
| A | WEI HAN ET AL: "Flattop focusing with full Poincaré beams under low numerical aperture illumination", OPTICS LETTERS, OPTICAL SOCIETY OF AMERICA, US, vol. 36, no. 9, 1 May 2011 (2011-05-01), pages 1605-1607, XP001562950, ISSN: 0146-9592, DOI: 10.1364/OL.36.001605 [retrieved on 2011-04-27] * the whole document * | 1-15 | **TECHNICAL FIELDS SEARCHED (IPC)** |
| A | CN 111 290 147 A (UNIV SHENZHEN) 16 June 2020 (2020-06-16) * abstract; claims 1-10; figures 1-4 * | 1-15 | |

The present search report has been drawn up for all claims

| Place of search | Date of completion of the search | Examiner |
|---|---|---|
| The Hague | 16 February 2024 | Beugin, Anne |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**ANNEX TO THE EUROPEAN SEARCH REPORT
ON EUROPEAN PATENT APPLICATION NO.**                    EP 23 30 6711

This annex lists the patent family members relating to the patent documents cited in  the above-mentioned European search report.
The members are as contained in the European Patent Office EDP file on
The European Patent Office is in no way liable for these particulars which are merely given for the purpose of information.

16-02-2024

| Patent document cited in search report | | Publication date | Patent family member(s) | | Publication date |
|---|---|---|---|---|---|
| EP 2965852 | A1 | 13-01-2016 | EP | 2965852 A1 | 13-01-2016 |
| | | | LT | 6250 B | 25-02-2016 |
| | | | LT | 2965852 T | 26-06-2017 |
| CN 111290147 | A | 16-06-2020 | NONE | | |

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **J. ARLT** ; **M. J. PADGETT**. Generation of a beam with a dark focus surrounded by regions of higher intensity: the optical bottle beam. *Opt. Lett.*, 2000, vol. 25, 191-193